(19) Europäisches Patentamt
European Patent Office
Office européen des brevets

(11) **EP 4 119 966 A1**

(12) **EUROPEAN PATENT APPLICATION**

(43) Date of publication:
**18.01.2023 Bulletin 2023/03**

(21) Application number: **21185900.4**

(22) Date of filing: **15.07.2021**

(51) International Patent Classification (IPC):
**G01R 31/58** (2020.01)   **G01K 11/32** (2021.01)
**G01D 5/353** (2006.01)   **G01B 21/18** (2006.01)

(52) Cooperative Patent Classification (CPC):
**G01D 5/35358; G01K 11/32; G01R 31/58**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **AP Sensing GmbH
71034 Böblingen (DE)**

(72) Inventor: **Lux, Jonathan
50735 Köln (DE)**

(74) Representative: **Dilg, Haeusler, Schindelmann
Patentanwaltsgesellschaft mbH
Leonrodstraße 58
80636 München (DE)**

(54) **EMPLOYING LOAD TEMPERATURE CORRELATION ANALYSIS FOR BURIAL STATE ANALYSIS OF AN ELECTRICAL POWER CABLE**

(57)   It is provided a method of estimating a burial state of a subsea electrical power cable (5), the method comprising: obtaining load data samples (4) pertaining to plural points in time (t) at one or more locations, the load data samples indicating an electrical load the power cable (5) is subjected to; obtaining temperature data samples (15, 16) pertaining to plural locations ($x_i$, i) along the power cable (5) and pertaining to the plural points in time; deriving, for each location ($x_i$), from the load data samples (4) and the temperature data samples (15, 16), a location specific covariance related quantity ($C_i(\Delta t)$) related to a covariance or a correlation of the load and a temporal temperature change; each covariance related quantity may be determined by multiplying the current at a particular point in time with the temperature change at a point shifted in time by $\Delta t$ over an extended period of time, and for a plurality of different shifts $\Delta t$. The state of the power cable is estimated based on analyzing the derived covariance related quantities ($C_i(\Delta t)$), without the need to perform thermal modelling. The maximum of the temperature increase, and its time-shift with regard to the point in time with regard to the load data sampling point depends on the burial state.

Fig. 1

EP 4 119 966 A1

**Description**

Field of invention

The present invention relates to a method and to an arrangement of estimating a state of a subsea electrical power cable, in particular regarding its burial depth, in particular employing distributed temperature sensing.

State of the art

Typically, operators of submarine power cables may regularly monitor the burial depth of the power cable in an annually or bi-annually survey which may be an expensive and time-consuming process. To monitor the state of the cable annually or bi-annually may not be sufficient, since it has been observed that the burial depth of a power cable may change on a much smaller timescale thereby exposing the cable to a risk of damage or in general malfunction. Among the most common threats of the power cable may be the exposure of the power cable to the seawater. When the power cable is exposed to the seawater, the cable may for example be damaged by anchors, fishery equipment or other sea ground activity. Furthermore, a shallow buried or even seawater exposed power cable may influence or even disturb the sea floor eco system with unpredictable long-term effects.

JPH10117424A discloses a power cable embedding depth measurement. The embedding depth of a power cable is determined, based on the temperature data of an embedded power cable, base temperature data of power cable embedding points, heating value data of the power cable, intrinsic heat resistance of soil where the power cable is embedded, and diffused intrinsic heat resistance of a power cable surface. The base temperature means, the sea floor surface temperature in the case of a submarine cable, and ground level temperature in the case of a land cable.

EP0825459A2 discloses a method for measuring the depth of a buried electrical power cable, wherein the underground-laying depth of an electric power cable is obtained on the basic of temperature data of the electric power cable laid underground, ambient temperature data of a place where the electric power cable is laid underground, calorific power data of the electric power cable, thermal resistivity of soil where the electric power cable is laid underground, and radiation thermal resistivity of the surface of the electric power cable.

WO2014056541A1 discloses a method for monitoring soil erosion around buried devices, instrumented device and system implementing the method, including measuring at least one temperature using at least one temperature sensing element located in the vicinity of the heat source(s), and calculating an estimated soil thickness using a pre-determined thermal distribution function which links measured temperatures and soil thickness.

CN106052614A discloses a method and device for monitoring subsea cable, the method including determining the time profile of the temperature of the submarine cable by means of a fiber optic system for measuring the temperature distributedly; measuring the time curve of the current flowing through the submarine cable; calculating the thermal resistance of the soil surrounding the submarine cable from the time curve of the measured temperature and current. The coverage height of the submarine cable is derived from the thermal resistance of the soil calculated by the resolution of the location.

WO2018154275A1 discloses monitoring subsea cables, by performing distributed fibre optic sensing on a sensing optical fibre to provide a measurement signal from each of a plurality of longitudinal sensing portions of the sensing optical fibre, the sensing optical fibre being deployed along the path of the subsea cable; and for at least one sensing portion, analysing a frequency spectrum of the respective measurement signal corresponding to pressure variations due to surface water waves to determine a burial status for that sensing portion.

EP3514488A1 discloses a method for monitoring a burial depth of a submarine power cable, including receiving the cable temperature curve through a cable optical fibre; splitting the cable temperature curve into a seawater temperature variation influence and a cable heating influence based on the seawater temperature; subtracting from the cable heating influence a soil-free cable heating influence, thereby obtaining a soil sea bed heating influence; and determining the burial depth based on the soil sea bed heating influence.

Xue- Feng Zhao, Le Li, Qin Ba, Jin- Ping Ou, "Scour monitoring system of subsea pipeline using distributed Brillouin optical sensors based on active thermometry", Optics & Laser Technology, Volume 44, Issue 7, October 2012, Pages 2125-2129 discloses a scour monitoring system of subsea pipelines using distributed Brillouin optical sensors based on active thermometry.

J. Lux, M. Olschewski, P. Schafer and W. Hill, "Real-Time Determination of Depth of Burial Profiles for Submarine Power Cables," in IEEE Transactions on Power Delivery, vol. 34, no. 3, pp. 1079-1086, June 2019, discloses Determination of Depth of Burial Profiles for Submarine Power Cables from DTS measurements.

Fabien Ravet, Cristian Silva, Rodolfo Gil, Simon Maguire, and Etienne Rochat, "Erosion Risk Mitigation with DTS Based Monitoring System" in Abu Dhabi International Petroleum Exhibition & Conference, Abu Dhabi, UAE, November 2020 discloses detection erosion along a pipeline with DTS Monitoring.

Thus, there may be a need for a method and a corresponding arrangement of estimating a state of a subsea electrical power cable, which is in particular reliable and/or less complex than conventional methods and in particular does not require expensive or complex additional monitoring or measuring equipment.

Summary of the Invention

The need may be satisfied by the subject-matter of the independent claims directed to a method and a corresponding arrangement for estimating a state of a subsea electrical power cable. Dependent claims specify particular embodiments of the present invention.

According to an embodiment of the present invention it is provided a method of estimating a state of a subsea electrical power cable, the method comprising obtaining load data samples pertaining to plural points in time, the load data samples indicating an electrical load the power cable is subjected to; obtaining temperature data samples pertaining to plural locations along the power cable and pertaining to the plural points in time; deriving, for each location, from the load data samples and the temperature data samples, a location specific covariance related quantity related to a covariance or a correlation of a load, and/or temporal load change and/or a load related quantity on one hand and a temporal temperature change or temporal temperature change related quantity on the other hand; and estimating the state of the power cable based on analyzing the derived covariance related quantities, in particular without performing thermal modelling.

The method may be implemented in software and/or hardware. The plural points in time may have the same or a different time distance in between.

The state of the subsea electrical power cable may in particular include an estimation of the burial state of the power cable, such as to estimate the burial depth, i.e. the distance between the power cable and the sea ground surface, and/or degree of exposure to the seawater, for example. The state may relate to information regarding the arrangement of the electrical power cable relative to the sea ground and/or relative to the seawater and/or the amount or thickness of soil or sand which covers the electrical power cable at the sea ground.

In particular, embodiments may enable estimation of the state of burial for submarine power cables, by employing or analysing a load temperature-change correlation function, i.e. analysing or detecting a (local, i.e. location dependent) correlation between power cable load (such as electrical current or power), or load change, or a load related quantity (such as any power of the electrical current, e.g. square of the electrical current) and (local) temperature, or temporal temperature change, of the power cable. Embodiments of the present invention may enable to detect exposure or more general the burial state and significant changes of the burial state (in particular burial depth) of a submarine power cable.

Embodiments of the present invention may employ only measured data (for example distributed temperature sensing DTS, temperature traces and cable load data) and may not require thermal modelling of the system comprising the power cable, the sea ground soil and the seawater. Quantities derived according to embodiments of the present invention may be sensitive to and/or dependent on the burial depth of the power cable. By comparing the values as obtained in embodiments of the present invention to typical values, critical locations along the power cables may be identified. Critical locations may for example include locations where the burial depth of the power cable is less than a threshold or the power cable is even exposed to seawater. Furthermore, when the quantities are tracked from calculation to calculation, according to embodiments of the present invention, significant changes (in particular temporal changes) in the state (in particular burial depth) of the power cable may be detected.

Embodiments of the present invention may enable continuous monitoring (in space and time) of full submarine power cables (for example in a length or distance which may be up to the measurable range of a conventional DTS system) without any physical measurement device installed at the sea ground. Embodiments of the present invention may be enabled to detect cable exposures and/or significant changes in the burial state, in particular burial depth, much faster than conventionally known. According to embodiments of the present invention, no additional measurement devices are required to be installed or be present at the sea ground. Embodiments of the present invention may employ a conventional DTS device which is however configured, by hardware and/or software to carry out or perform methods according to embodiments of the present invention.

The only sensor required beyond a DTS system (or other temperature measurement equipment) may be a load sensor, for example being configured to measure or detect an electric current and/or electric power conveyed through the power cable. Embodiments of the present invention may allow continuous monitoring of the power cable regarding its state, in particular burial state, the monitoring being both in space and time. Embodiments of the present invention may not require quantitative knowledge of thermal parameters and/or may not require any knowledge of ambient conditions. Furthermore, embodiments may not require any thermal modelling of the system comprising the power cable, the sea ground soil and/or the surrounding water. Embodiments of the present invention may be independent of IEC standard 60287 formulas, or other calculation methods, for heat dissipation. Embodiments may also not require any specifications of accuracies which may be complicated and hard to communicate for quantitative approaches. Embodiments of the present invention may allow a faster feedback time and may require less data to be processed and acquired.

The electrical power cable may for example electrically connect a power production facility, such as an offshore wind farm, to a offshore or onshore converter station and/or to an offshore or onshore receiver station. The electrical power cable may be equipped with at least one optical fibre which may be part of a DTS system. The optical fibre may therefore be installed in, at or close to the power cable. The optical fibre may be for example integrated in or adjacent to the insulation of a high-voltage power cable. The electrical power cable may be a conventional power cable equipped with at least one optical fibre. The electrical power cable may be intended to be installed at or below the sea ground at a particular burial depth, in order to protect the power cable from damage due to any events in the environment at the sea ground.

The load data samples may relate to the electric current load and/or electrical power load (or to any load related quantity) at the plural points in time the electrical power cable is subjected to. The load related quantity may e.g. be derived to be proportional to a particular power of the electrical current, such as the square of the electrical current or any higher order, or may be a polynomial of the electrical current or the power, or another mathematical function of the electrical current or the power. The load data samples may for example be measured at only one or more locations which are easily accessible and which may comprise at least one current and/or power sensor installed.

In other embodiments the load may show a spatial dependency, for example in the presence of reactive currents, and the local current may for example be interpolated from reactive current profiles. The load or load related quantity or reactive current may therefore be measured at plural locations along the cable, respectively at the plural points in time, in order to derive a location dependent load for the plural points in time, to provide the load data samples. In these embodiments, load data samples may be taken (for each of one or more of the plural points in time) at more than one location. For example, an average value may be derived serving as the electrical load the power cable is subjected to at a particular point in time or a particular range in time or the spatially dependent load may be utilized to determine the covariance or correlation (with the temperature change) related quantities for the plural locations.

The method may require that the electrical load or electrical current or electrical power conveyed to the cable is greater than zero. Embodiments of the present invention may require that the load the cable is subjected to is different from being constant, i.e. that the load changes with time (across the plural points in time). The electrical load, in particular electrical current and/or electrical power, may typically change with time in case of a wind farm, for example installed offshore due to changing wind condition.

Embodiments of the present invention may also require that the temperature as represented by the temperature data samples changes with time (across the plural points in time). The temperature data samples may be obtained by plural local temperature sensors installed for example along the electrical power cable or may in particular be acquired employing a distributed temperature sensing system. Thus, the temperature data samples may be obtained by employing a conventional DTS system. The DTS system may provide spatially and temporarily resolved temperature data relating to the temperature close to or at the power cable at the plural locations for the plural points in time.

The location specific covariance related quantity may give or represent a quantity pertaining to a particular location of the plural locations. The covariance related quantity may relate to a covariance or a correlation of a load related quantity and a temperature change related quantity.

The temperature change related quantity may be derivable from the temperature change for each location, may e.g. be a polynomial or any power of the temperature change.

When the load for example changes in a stepwise manner, the temperature may be expected to rise in a temporal manner dependent on the environment of the cable in particular depending on the burial state of the power cable. The temporal manner in which the temperature rises may depend on the heat conductive properties of the material surrounding the electrical power cable. If the material surrounding or being at least in contact with portions of the power cable has relatively great heat conduction or transfer coefficient, the temperature raise may be faster compared to the case when the surrounding material has a smaller heat conduction coefficient. Therefore, analysing the derived covariance related quantities may enable to estimate the state of the subsea electrical power cable. Thereby, thermal modelling may not be required which has conventionally been observed to be complicated and time-consuming as well as inaccurate under many conditions.

In particular, for each of the plural locations, plural temperature data samples may be available. The plural data samples pertaining for each of the locations may represent the temperature in, at or close to the power cable at the plural points in time. In contrast, the load data samples may not be required to be known for each of the plural locations, since the electrical current or electrical power conveyed through the cable may be assumed to vary slowly, if it all, among the plural locations. Thus, the load may not be required to be measured or available at each of the plural locations.

According to an embodiment of the present invention, for each location and for each of plural time shifts, the covariance related quantity is derived based on the load data samples and the temperature data samples related to points in time shifted by the respective time shift.

For each one of the plural time shifts, the load data samples may be taken at the plural points in time and the temperature data samples may be taken at the plural points in time as well as at the sum of the plural points in time plus the one of the plural time shifts. For each one of the plural time shifts, the covariance related quantity may be derived to be for example proportional to a sum of products depending on the load data samples and the temperature data samples. The covariance related quantity may be normalized in an appropriate manner depending on the particular application. For example, the covariance related quantity may be normalized by dividing through for example the standard deviation (or median or mean) of the load data and the standard deviation of the temperature data samples. Other normalizations may be applied. For example, the covariance related quantity may be normalized by dividing through an expected load and by dividing through a expected temperature of the power cable observed for the expected load. Thereby, flexibility may be increased and the covariance related quantity may be adapted for the particular application.

According to an embodiment of the present invention, the method may be performed for plural different time windows, wherein for each of the time windows, a procedure as described above may be performed. Details will be explained below.

The load data samples as well as the temperature data samples are considered at the plural points in time for each of the plural time shifts, in order to derive the covariance related quantity for each of the plural time shifts. The load data samples and the temperature data samples may enter as a product for each of the plural points in time. The product for the plural points in time may be summed for deriving the covariance related quantity.

According to an embodiment of the present invention, for each location and for each of plural time shifts, the covariance related quantity is derived depending on a sum, over the plural points in time, of a product of the respective load data related quantity at a respective point in time and the respective temperature data sample at the respective point in time shifted by the respective time shift. The covariance related quantity may be derived not only depending on the sum, but may be derived as being proportional to the sum as defined above.

The sum may be taken from a start time to an end time which may be between one week and ten weeks after the start time. Each member of the sum may contain a product of a first and a second factor, the first factor being the load, or a power of the load, potentially normalized or centralized in the respective time window, at the respective point in time and the second factor, being dependent on the temperature at the point in time shifted by the considered time shift diminished by the temperature at the respective point in time.

The covariance related quantity may be derived to be proportional to the sum, as defined above. The sum runs over the plural points in time and each member of the sum comprises a product. The product may depend on the load at the respective point in time and a quantity depending on the temperature of the point in time shifted by the considered time shift.

According to an embodiment of the present invention, for each location and for each of plural time shifts, the covariance related quantity is derived depending on a sum, over the plural points in time, of a product of the respective load data sample and a temperature difference, the temperature difference being a difference between the respective temperature data sample at the respective point in time shifted by the respective time shift and the temperature data sample at the respective point in time.

The covariance related quantity may be derived to be proportional to the sum as defined above. The load may change with time across the plural points in time. In particular, the load may be required to change between at least two points in time of the plural points in time. The empirical covariance may be derived as a sum of a product of differences, the first factor being the load diminished by the average or mean load, the second factor being the temperature diminished by the mean or average temperature. The sum may run across the plural points in time. The empirical correlation may be calculated similarly, wherein the empirical covariance may be scaled by dividing it through the square root of the product of the variances of the load and the temperature.

When the covariance related quantity is derived considering the temperature difference, the influence of a potentially or possibly varying ambient temperature or a temperature offset may be diminished or decreased. The temperature difference may in other embodiments for example be calculated as difference between the respective temperature data sample at the respective point in time shifted by the respective time shift and an average or a mean temperature of the power cable, for example taken across different temperatures across the plural points in time. Thereby, the estimation of the state of the power cable may be improved.

According to an embodiment of the present invention, for each location and for each of plural time shifts, the covariance related quantity is derived as an empirical covariance or an empirical correlation between the load data samples and the temperature data samples at points in time shifted by the respective time shift, and/or wherein, for each location and for each of plural time shifts, the covariance related quantity is derived as an empirical covariance or an empirical correlation between the load data samples and temporal temperature differences, each temporal temperature difference being derived as a difference between a respective temperature data sample related to the point in time shifted by the respective time shift and the temperature data sample related to the respective point in time.

For each of the plural time shifts and each location, the empirical covariance may be calculated as sum over the plural points in time of the product of a first factor being the difference between the load at the respective point in time and the average or mean load and a second factor being the difference between the temperature at the respective point in time and the mean or average temperature across the different points in time. Thereby, the method may employ conventionally available algorithms for calculating the covariance. The empirical correlation may be derived as a normalized empirical covariance, wherein the empirical covariance is divided by the square root of the variances of the load and the temperature of the power cable (across the plural points in time). Thereby, plural different manners how to calculate the covariance related quantity are provided, increasing the flexibility and adaptability of the method to the particular application.

According to an embodiment of the present invention, analyzing the covariance related quantities comprises, for at least one location, finding, as a first analysis value, a location specific maximal value of the covariance related quantity across the plural different time shifts, wherein estimating the state, in particular burial state, of the power cable is based on the first analysis result.

The location specific maximal value of the covariance related quantity may be one indicator of the burial state of the power cable. The closer the cable is arranged to the seawater, the faster the dissipated heat can be transported away. Therefore, a (comparatively) smaller value of the location specific maximal value relative to neighbouring locations, may indicate a (comparatively) lower burial depth assuming that this is the only (or major) changing variable which correlates with the location specific maximal value of the covariance related quantity. Embodiments of the present invention may scan or search the available data (across the plural different time shifts) for small values of the location specific maximal value of the covariance related quantity (and optionally also the corresponding time shift, see below), in order to identify locations of the power cable which are possibly (partly or entirely) exposed to the seawater or are arranged at a smaller burial depth than other locations along the power cable.

According to an embodiment of the present invention, the method further comprises determining a scaled first analysis value by scaling the first analysis value based on a, in particular location specific, normalization value, in particular a mean or a median or a typical or an expected or a calculated value of the covariance related quantities, wherein estimating the state of the power cable is based on the scaled first analysis result.

The scaling of the first analysis value may be obtained by dividing the first analysis value by the normalization value. The scaling or the normalization may simplify the interpretation of the obtained result, i.e. the scaled first analysis value. The scaled first analysis value may be less dependent on external quantities, such as the load, the seaground temperature, the water temperature or the thermal transport properties of the surrounding. Thereby, the method may further be improved.

According to an embodiment of the present invention, estimating the state of the power cable is based on whether the scaled first analysis result is within or outside a predetermined range around a reference value and/or below or above a predetermined threshold, and/or wherein a problematic location of the power cable is identified for which the scaled first analysis result is at least by a threshold deviation below the reference value; and/or the method further comprising: defining a global and/or section wise threshold of the scaled first analysis result for giving an alarm or a pre-alarm and/or warning.

The scaled first analysis result may be expected, for a correctly buried power cable, to have a value within the predetermined range or stay outside the predetermined range around the reference value. The reference value and/or the predetermined threshold may have been determined earlier from for example training data examining a power cable having a known burial state and having known exposure or degree of exposure to seawater, and/or from simulations and/or from analytic calculations. Therefore, according to embodiments of the present invention, calibration measurements may be available comprising values of the scaled first analysis result for different known states of the power cable, in particular different burial states. Thus, for an actual power cable to be monitored regarding its state, an inference can be performed in the sense to estimate the burial state based on the first analysis result and/or the scaled first analysis result, thereby considering the analysis of the training data and/or calibration data and/or simulation data.

A problematic location of the power cable may for example relate to a location where the power cable is less than a threshold depth below the seabed or sea ground or where the power cable has a degree of exposure to seawater above a particular degree or percentage. One or more thresholds may be defined, which may apply across the entire length of the power cable or may only apply section-wise, i.e. only at particular locations along the power cable. Thereby, environmental particularities, such as soil properties, water stream particularities and other environmental factors may be accounted for.

According to an embodiment of the present invention, analyzing the covariance related quantities comprises for each location, finding the first analysis value; finding, across the plural locations, one or more local minima of the first analysis value, in order to detect potential problematic locations.

The first analysis value may be different for the different locations along the cable. In general, lower values may indicate that the respective environment or surrounding of the location of the power cable has relatively high thermal conductivity, or other thermal transport coefficient, for example indicating to a higher percentage or degree of exposure to seawater and/or smaller burial depth. Exposure to seawater and/or smaller burial depth may be identified, where the local minima of the first analysis value are observed across the plural locations. Thereby, a simple procedure may be provided, for detecting problematic locations of the power cable.

According to an embodiment of the present invention, analyzing the covariance related quantities comprises, for at least one location, finding, as a second analysis value, a location specific time shift for which the covariance related quantity for the respective location is a maximal value, wherein estimating the state of the power cable is further based on the second analysis result.

The second analysis value is the location specific time shift for which the covariance related quantity for the respective location is a maximal value. If the location specific time shift is relatively small, it may indicate relatively low burial depth and/or relatively high exposure to seawater. The estimating the state of the power cable may be based on the first analysis result and/or scaled first analysis result and/or second analysis result and/or scaled second analysis result. Combining different analysis quantities may further improve the accuracy and reliability of the method. Also the second analysis result may be scaled by an application specific normalization, for example considering a typical value for the second analysis value which may have been derived analysing training data for which the respective burial state of the power cable is known, and/or from simulations and/or from analytic calculations.

According to an embodiment of the present invention, analyzing the covariance related quantity comprises analyzing, for at least one location, the behavior of the covariance related quantity at small time shifts, in particular being smaller than the respective second analysis result, in particular regarding steepness of increase, in order to obtain a third analysis result, and/or analyzing, for at least one location, the behavior of the covariance related quantity at large time shifts, in particular greater than the respective second analysis result, in particular regarding steepness of decline and or curvature, in order to obtain a fourth analysis result, wherein estimating the state of the power cable is further based on the third analysis result and/or the fourth analysis result, and/or applying a decision algorithm and/or rule-based algorithm to derive the state based on one of more features of the covariance related quantities.

In general, for any location, any properties of the curve of the covariance related quantity for the plural time shifts may be evaluated or discussed, for example regarding properties of the first derivative, properties of the second derivative and also absolute values. Analyzing more aspects of the covariance related quantity for the different time shifts and considering those properties in the analysis may further improve the reliability and accuracy of the method. Also for the third analysis result and/or the fourth analysis result, particular normalization or scaling may be applied, for example utilizing typical or expected or mean or median third analysis result and a typical or expected or mean or median fourth analysis result for a power cable for which the burial state or in general the state is known.

When efficient training data are available (based on utilizing temperature data and load data of a power cable having a known burial state at the plural locations), one or more of the aforementioned analysis quantities, i.e. the first analysis result, the second analysis result, the third analysis result and/or the fourth analysis result, may be combined for deriving an estimation regarding the burial state or in general the state of the power cable.

According to an embodiment of the present invention, the method further comprises obtaining further load data samples pertaining to plural further points in time; obtaining further temperature data samples pertaining to the plural locations along the power cable and pertaining to the plural further points in time; deriving, for each location, from the further load data samples and the further temperature data samples, a further location specific covariance related quantity related to a covariance or a correlation of the further load and a further temporal temperature change, wherein estimating the state of the power cable is further based on analyzing the further covariance related quantities, in particular involving forming a difference between the scaled first analysis result and a scaled further first analysis result.

When the method is applied to plural further points in time, the temporal change of the state of the power cable, in particular burial state, may be monitored. When for example it is detected that the state as estimated at the plural points in time (e.g. first time window) deviates from the state as estimated related to the further plural points in time (e.g. second time window), it may be concluded that an event happened in between which caused the change of the state of the power cable, such as an anchor disturbing the sea floor close to the power cable or construction activity at the sea ground or the like. When the change of the estimated state is for example greater than a threshold, an alarm may be raised. In other embodiments, when the respective analysis results, i.e. the first, the second, the third, the fourth analysis result, change more than a respective threshold, an alarm may be raised.

The plural further points in time may or may not overlap with the points in time. Performing the method at or relating to plural further points in time may enable to monitor temporal changes of the burial state of the power cable. Also for the further points in time or the further analysis of the burial state of the power cable, the (first/second/third/fourth) analysis results as defined above may be derived and considered for estimating the burial state. When the difference between the scaled first analysis result and the scaled further first analysis result is larger than a difference threshold, it may indicate a drastic change of the burial state of the power cable, in this situation, an alarm may be raised or indicated to a user.

According to an embodiment of the present invention, the plural different time shifts include time shifts ranging from 0 hours to 20 hours, and/or the plural points in time cover a range of between one week and ten weeks, in particular between one week and four weeks, and/or wherein estimating the state of the subsea electrical power cable includes at least one of: estimation of an extent of exposure to water and/or soil; qualitative or quantitative estimation of burial state and/or change of burial state and/or burial depth and/or change of burial depth.

The plural different time shifts may include time shifts covering a time duration which may be defined depending on the application. For example, 10 to 100 different time shifts may be considered and the respective covariance related quantity may be derived for these 10 to 100 different time shifts. For each considered time shift, the covariance related quantity may be derived as a sum over 10 to 10,000 members covering the plural points in time. A quantitative estimation of the burial state may be arrived at by considering one or more of the above-mentioned analysis results separately and/or assessing respective values in combination, for example in a regression, a decision tree or the like or neural network.

According to an embodiment of the present invention, obtaining the temperature data samples comprises acquiring measuring data of a fibre optic distributed temperature sensing system employing a fibre arranged at or in or on the power cable, the temperature sensing system in particular utilizing at least one of Raman scattering, Brillouin scattering, Raleigh scattering, and/or wherein obtaining the load data samples comprises: measuring or deriving electrical power conveyed through the cable, in particular including measuring voltage and/or current and/or power at one or more locations.

The distributed temperature sensing system may be configured to measure temperatures at different locations by means of optical fibres functioning as linear sensors. The DTS system may for example provide a spatial resolution of temperature distribution of between 10 cm and 2 m or 5 m with an accuracy for example to be within $\pm$ 1°C at a resolution of 0.01°C. The length of the electrical cable monitored by the DTS system may be between 5 km and 70 km, for example.

Raman scattering may involve electronic excitation of a molecule within the optical fibre and relaxation into a state being different from the initial state. Thereby, so-called stokes and anti-stokes transitions may occur resulting in the emission of light having a wavelength shorter and longer than the wavelength of the incident light. By measuring the ratio of intensities of the different emitted lights having different wavelengths, the temperature at the respective location (detected by tracking time of arrival at the detector) of the fibre may be derived. In other embodiments, Brillouin scattering and/or Rayleigh scattering may also be utilized in order to obtain temperature information. Thereby, algorithms and techniques known in the art may be applied.

The distributed temperature sensing system may comprise a radiation source, such as a laser, for generating coherent light. The system may further comprise a light modulator, being configured to generate pulses of coherent light and may be configured to inject the pulses of coherent light into the optical fibre. Thereby, an optical coupler may be employed. Further, the system may comprise a detector system which may be configured to distinguish light of different wavelengths and measure respective intensities. The processor may be configured to perform analysis of the obtained data with respect to the temperature data samples and also to analyze or process data regarding load measurements of the load the power cable is subjected to.

It should be understood, that features, individually or in any combination, disclosed, applied, explained or provided for a method of estimating a state of a subsea electrical power cable may, individually or in any combination, also applied to an arrangement for estimating a state of a subsea electrical power cable, according to embodiments of the present invention and vice versa.

According to an embodiment of the present invention it is provided an arrangement for estimating a state of a subsea electrical power cable, in particular distributed temperature sensing system, the arrangement comprising a processor adapted: to obtain load data samples pertaining to plural points in time, the load data samples indicating an electrical load the power cable is subjected to; to obtain temperature data samples pertaining to plural locations along the power cable and pertaining to the plural points in time; to derive, for each location, from the load data samples and the temperature data samples, a location specific covariance related quantity related to a covariance or a correlation of a load related quantity (e.g. load) and a temporal temperature change related quantity (e.g. temporal temperature change); and to estimate the state of the power cable based on analyzing the derived covariance related quantities, the arrangement in particular further comprising an optical fibre arrangeable in, at or close to the power cable; a light pulse generator adapted to generate primary light pulses and inject them into the optical fibre; a detector adapted to detect secondary light pulses returning from the optical fibre after having interacted with the fibre at plural locations, the processor being further adapted to process the detect secondary light pulses, in order to derive the temperature data samples for the plural locations.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

Brief Description of the Drawing

Embodiments of the present invention are now described with reference to the accompanying drawings. The present invention is not restricted to the illustrated or explained embodiments.

Figure 1 schematically illustrates an arrangement for estimating a state of a subsea electrical power cable according to embodiments of the present invention, in the illustrated embodiment configured as a DTS system;

Figure 2 illustrates temperature sample data as considered in embodiments of the present invention;

Figure 3 illustrates analysis results as derived according to embodiments of the present invention relating to different time periods; and

Figure 4 schematically illustrates analysis results as derived according to embodiments of the present invention relating to different time periods.

Detailed Description

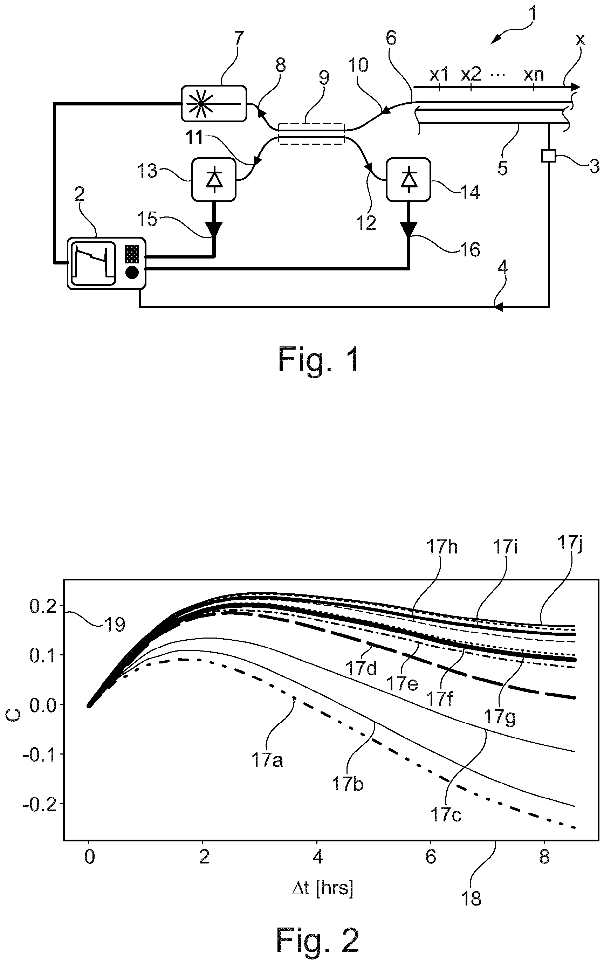

The arrangement 1 for estimating a state of a subsea electrical power cable 5 illustrated schematically in **Figure 1** is configured to estimate a state of a subsea electrical power cable 5. In the embodiment illustrated in Figure 1, the arrangement 1 is configured as a distributed temperature sensing system comprising an optical fibre 6 which is arranged in, at or close to the electrical power cable 5.

The arrangement 1 comprises a processor 2 which is adapted to obtain load data samples 4 from a current or power sensor device 3 pertaining to plural points in time, wherein the load data samples 4 indicate an electrical load the power cable 5 is subjected to. The electrical measurement device 3 measures for example the current and the voltage conveyed through the electrical power cable 5. The arrangement 1 comprises a radiation source 7 which is configured to generate primary pulses 8 of coherent electromagnetic radiation, for example coherent light (e.g. infrared and/or visible and/or ultraviolet), for example by employing a laser. The primary generated coherent light pulses 8 are injected into the optical fibre 6 and are conveyed through a wavelength division multiplexer 9 before reaching a section of the fibre 6 in, or in close proximity, to the power cable 5 to be monitored regarding its state. Within the optical fibre 6, the coherent pulsed light 8 is scattered by processes known as Raman, Brillouin and Rayleigh scattering. Thereupon, light, having different wavelengths in case of Raman and Brillouin scattering, than the primary radiation pulses 8 is scattered back, indicated as secondary backscatter light 10. In particular, the backscatter light 10 may comprise light pulses having a smaller wavelength as well as light pulses having a greater wavelength than the wavelength of the primary radiation 8. The scattered light 10 is conveyed through the wavelength division multiplexer 9 in order to separate the scattered light 10 in first scattered light 11 characterized as having experienced stokes scattering as well as divided into second scattered light 12 being characterized by having experienced anti-stokes scattering. The intensities of the first scattered light 11 as well as the second scattered light 12 are detected by respective detectors 13, 14 which transmit respective intensity data 15, 16 (one example of temperature data samples) to the processor 2.

Thus, the processor 2 not only obtains the load data samples 4, but also the temperature data samples 15, 16 pertaining to plural locations along the power cable 5 and pertaining to plural points in time. The processor 2 is further configured to derive, for each location (for example each location along an axis x or a line arranged along the power cable 5) x_i, from the load data samples 4 and the temperature data samples 15, 16, a location specific covariance related quantity related to a covariance or a correlation of the load and a temporal temperature change. The processor 2 is further configured to estimate the state of the power cable 5 based on analyzing the derived covariance related quantities.

The correlation or covariance related quantity may be derived in a number of different manners, as has been explained above. Below, a particular implementation is described in detail.

In general, the accurate calculation of the burial depth of a submarine power cable may be very challenging. Conventionally, it may require precise and spatially resolved knowledge of the ambient conditions and the thermal parameters of the sea ground. Often, this data is not available in sufficient quality for real-time applications. Furthermore, it may depend on the absolute measured temperature and thus may be influenced by poorly calibrated DTS devices and measurement uncertainties at long distances. In addition, there may be a theoretical limit on the detectable burial depth (which may depend on the load, the ambient conditions, the temperature repeatability of the measurement device). The conventionally applied thermal modelling of the heat flow in the system comprising the power cable, the sea ground and the seawater may use the IEC standard 60287, in order to calculate the heat dissipation in the power cable. These conventionally utilized formulas are, however, not designed for high accuracy but for a safe cable operation. Thus, these conventionally used formulas and methodologies may introduce an uncontrollable bias which could only be avoided by more precise formulas for the heat dissipation which are unfortunately not available.

Embodiments of the present invention enable to estimate the state of the cable and the change of the state of the cable. Embodiments of the present invention may enable to estimate whether the cable is exposed to seawater or for example whether the burial depth changes significantly (spatially and/or temporally). Embodiments of the present invention utilize only measured temperature data and load data (for example DTS temperature traces and cable load measurements) and do not require thermal modelling.

The processor 2 illustrated in Figure 1 may calculate a covariance related quantity (also referred to as a local load temperature-change correlation function) as follows:

$$C_i(\Delta t) = \sum_t^{T_{max} \sim weeks} I(t) \times \left( T_i(t + \Delta t) - T_i(t) \right),$$

eq. (1)

Herein, I(t) denotes the cable load at a time t and $T\_i(t)$ is the measured DTS temperature at a time t and a location i (i.e. x_i). In Equation 1 there is one free parameter T_max which may be adjusted according to the particular application. A smaller value of T_max may correspond to faster feedback times, while a larger value reduces the noise and may compensate for time ranges of constant load. In practice, a value for T_max may be between two weeks and four weeks.

**Figure 2** illustrates exemplary values of the covariance related quantity C for **different locations x_i of the power cable. Therein, each curve 17a, ..., 17j relates** to a different location x_i along the electrical power cable 5. The curve 17a, 17b, **..., 17j pertain to the locations 18 m, 20 m, ..., 38 m** along the electrical power cable 5, the locations being defined with respect to a start position. The curves **17a, 17b, ..., 17j are depicted** in a graph having as an abscissa 18 indicating the time shift $\Delta t$ and having an ordinate 19 indicating the value of the covariance related quantity. The covariance related quantity is also denoted as C. For example, $C\_i(\Delta t)$ indicates the covariance related quantity at the location x_i and at the time shift $\Delta t$.

As can be seen from equation (1), the covariance related quantity is calculated for each location x_i and for each of plural time shifts $\Delta t$, as a sum over plural points in time t=0, ..., t=T_max. Each member of the sum is a product between the load at the considered point in time and a temperature difference of the temperature at the considered point in time shifted by the time shift diminished by the temperature at the considered point in time. By construction of equation (1) it holds that $C\_i(0)=0$.

The time dependence at the location i shows a maximum value M_i at some time $\tau\_i$ defined by

$$M_i = \max_{\Delta t} C_i(\Delta t) = C_i(\tau_i).$$

eq. (2)

The value M_i and the time scale $\tau\_i$ are both indicators of the burial state of the cable. The closer the cable is to the water (i.e. the smaller the burial depth), the faster the dissipated heat can be transported away. Hence, small values of both M_i and $\tau\_i$ relative to neighbouring locations, may indicate a (relatively) lower burial depth (assuming that this is the only changing variable which correlates with C).

In Figure 2 it can be observed that the power cable 5 is transitioning from the buried sea section (> 25 m), i.e. between curves 17c and curve 17d to the onshore section (< 20 m) around the locations shown in Figure 1. It can be assumed that the cable 5 is exposed to the seawater in this transition section. At locations between 20 m - 25 m (curves 17a, b, c), the maximum value M_i is smaller by a factor 2 to 3 compared to the neighbouring locations (see curves 17a,b,c which show a smaller maximum of the covariance related quantity C than the other locations). The observation that the maximum value of the covariance related quantity C shows different values for different environment may be utilized to identify locations where the heat transport behaves differently compared to "typical", i.e. buried, locations.

According to embodiments of the present invention, the maximum value M_i represents a first analysis result. The time shift $\tau\_i$ may represent a second analysis result according to an embodiment of the present invention. At the locations 20 m - 25 m, also the time shift $\tau\_i$ representing a second analysis value and also referred to location specific time shift for which the covariance related quantity for the respective location is a maximal value, is also reduced by a factor 1.5 - 2.5 at these locations relative to neighbouring locations.

According to an embodiment of the present invention, a scaled first analysis value may be obtained from the value M_i by applying a scaling or normalization. In particular, to compare the results at different times, the quantity M_i representing a first analysis result (or first analysis value) is scaled by its median according to the following formula

$$S_i = M_i / \text{median}(M_i)$$

eq. (3)

The scaling may reduce or remove the dependency on the load level in the considered time range.

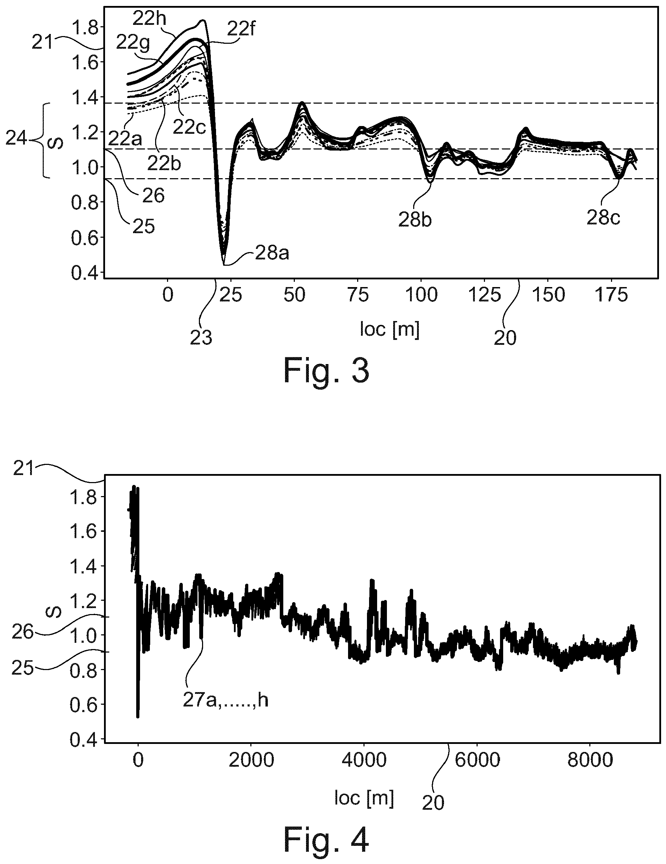

**Figure 3** illustrates the scaled first analysis value S for different locations which are indicated at the abscissa 20. The ordinate 21 indicates the scaled first analysis value S_i which is derived according to equations (1), (2) and (3).

The **different curves 22a, 22b, ..., 22h are all calculated according to equations (1),** (2), (3), however, starting at different points in time t (e.g. being between one week and several weeks apart from each other), i.e. the sum in equation (1) running over different points in time (or different time windows). Thereby, the **curves 22a, ..., 22h indicate the temporal change of the scaled first analysis** value. One can easily identify the critical locations at the dip around a location 23 (around 22 m).

According to an embodiment of the present invention, a range 24 may be defined representing typical values of the scaled first analysis value $S_i$ for a correctly buried or arranged power cable within the sea ground. If it is found that the scaled first analysis is within the predetermined range 24, it may be concluded or estimated that the burial state is in proper or normal. If, however, the scaled first analysis value is outside the predetermined range 24 or below a threshold 25, it may be concluded that the power cable is exposed to seawater and/or has an insufficient burial depth or in general defective.

Other embodiments of the present invention may define a reference value or typical value 26 the scaled first analysis value. If the determined first analysis value deviates less than a threshold value from the reference value 26, it may be concluded that the burial state of the power cable is not critical. However, if the scaled first analysis value deviates by more than a determined threshold from the reference value or typical value 26, it may be concluded that the power cable has excessive exposure to seawater and/or has a too low burial depth.

In Figure 3, several local minima 28a, 28b, 28c may be identified as potentially critical locations.

**Figure 4** illustrates the scaled first analysis result S for a longer range of locations. **In Figure 4, the curves 27a, ..., 27h** represent the scaled first analysis value as obtained for different time windows. Thus, several kilometres or even several tenth of kilometres of an electrical cable may be monitored in a comparative manner according to embodiments of the present invention.

Between each of the successive curves as depicted in Figures 3 and 4, one to two weeks have elapsed. Thus, Figures 3 and 4 depict the temporal change of the scaled first analysis result for the plural locations indicated at the abscissa 20. It can be observed that the value of S (i.e. the scaled first analysis value) does not change significantly over several months. This may indicate the robustness of the method against changing ambient and load conditions. If the thermal properties of the sea ground change spatially along the cable route, the analysis may be performed section-wise as these parameters also may influence the values of the correlations. If the values of S are tracked from calculation to calculation, changes of the depth in either direction may be detected.

In equation (1), only temperature differences enter, which may guarantee that the result is independent of varying ambient temperature (to first order) and/or temperature offsets, e.g. due to miscalibration. Furthermore, uncorrelated contributions may cancel, if the timescale T_max is chosen appropriately, i.e. to be much larger than the correlation time of the additional effect. For example, daily temperature cycles have been observed caused by solar radiation in real project in a very shallow water.

From Equation (1) it is evident that for a vanishing load (I(t)=0), i.e. the cable is turned off, the method cannot be performed. The same holds when the load is constant at some finite value and the temperature is at its stationary value and does not change. Typically, however, the load of the power cable changes and therefore also the temperature will change accordingly. A constant current is typically not observed in wind farm applications, as the load varies with the wind condition and weather conditions. This might be different for interconnector or supply cables, where the load may be controlled by the cable operator. The influence of both effects may be mitigated by choosing a larger value for the timescale T_max.

An implicit, but very reasonable, assumption may be that the cable is safely buried at most of the locations such that the median value of M may represent a typical value for the buried cable. For example, in the extreme case where the full cable is exposed to the seawater, the correlations at all locations may be similar and no pronounced minima at critical locations would be observed.

The following details may be applied in particular embodiments:
A global and/or section-wise threshold for indicating an alarm when the threshold is exceeded may be defined. If, for example, the scaled first analysis value is below a globally or section-wise defined threshold, an alarm may be indicated.

Embodiments of the present invention may scan for local minima to identify critical locations. For example, in Figure 3, a critical location at a location 23 may be identified. Not only the scaled first analysis value but also the second analysis value $\tau_i$ may be considered and used in combination with the first analysis value or the scaled first analysis value in order to estimate the burial state of the power cable. Other properties of the curves as depicted in Figure 2 may also be determined and utilized in combination with other analysis values for estimating the state of the power cable.

Furthermore, the changes in the first analysis value (or other analysis values as explained above) from calculation to calculation at different time intervals or time ranges may be tracked, in order to detect significant depth changes early.

Further embodiments may utilize the method in order to double-check/verify results of a quantitative approach. For example, thermal modelling may be evaluated.

**Claims**

1. Method of estimating a state of a subsea electrical power cable (5), the method comprising:

obtaining load data samples (4) pertaining to plural points in time (t), and in particular to one or more points in space, the load data samples indicating an electrical load the power cable (5) is subjected to;

obtaining temperature data samples (15, 16) pertaining to plural locations ($x\_i$) along the power cable (5) and pertaining to the plural points in time;

deriving, for each location ($x\_i$), from the load data samples (4) and the temperature data samples (15, 16), a location specific covariance related quantity ($C\_i(\Delta t)$) related to a covariance or a correlation of a load related quantity, in particular the load, and a temporal temperature change related quantity, in particular a temporal temperature change; and

estimating the state of the power cable based on analyzing the derived covariance related quantities ($C\_i(At)$), in particular without performing thermal modelling.

2. Method according to the preceding claim,
wherein, for each location ($x\_i$) and for each of plural time shifts ($\Delta t$), the covariance related quantity ($C\_i(\Delta t)$) is derived based on the load data samples (I(t), 4) and the temperature data samples (15, 16) related to points in time shifted by the respective time shift ($\Delta t$).

3. Method according to one of the preceding claims,
wherein, for each location ($x\_i$) and for each of plural time shifts ($\Delta t$), the covariance related quantity is derived depending on a sum, over the plural points in time, of a product of the respective load data sample (I(t), 4) at a respective point in time (t), or a polynomial function thereof, and the respective temperature data sample ($T\_i(t + \Delta t)$) at the respective point in time (t) shifted by the respective time shift ($\Delta t$).

4. Method according to one of the preceding claims,
wherein, for each location ($x\_i$) and for each of plural time shifts ($\Delta t$), the covariance related quantity ($C\_i(\Delta t)$) is derived depending on a sum, over the plural points in time, of a product of the respective load data sample and a temperature difference ($T\_i(t + \Delta t) - T\_i(t)$), or a polynomial function thereof, the temperature difference being a difference between the respective temperature data sample $T\_i(t + \Delta t)$ at the respective point in time shifted by the respective time shift and the temperature data sample $T\_i(t)$ at the respective point in time.

5. Method according to one of the preceding claims,

wherein, for each location and for each of plural time shifts, the covariance related quantity is derived as an empirical covariance or an empirical correlation between the load data samples and the temperature data samples at points in time shifted by the respective time shift, and/or

wherein, for each location and for each of plural time shifts, the covariance related quantity is derived as an empirical covariance or an empirical correlation between the load data samples and temporal temperature differences, each temporal temperature difference being derived as a difference between a respective temperature data sample related to the point in time shifted by the respective time shift and the temperature data sample related to the respective point in time.

6. Method according to one of the preceding claims,

wherein analyzing the covariance related quantities ($C\_i(\Delta t)$) comprises, for at least one location ($x\_i$), finding, as a first analysis value ($M\_i$), a location specific maximal value of the covariance related quantity across the plural different time shifts ($\Delta t$),

wherein estimating the state, in particular burial state, of the power cable is based on the first analysis result.

7. Method according to the preceding claim, further comprising:

determining a scaled first analysis value ($S\_i$) by scaling the first analysis value ($M\_i$) based on a normalization value, in particular a spatial mean or a spatial median or a typical or an expected value of the covariance related quantities,

wherein estimating the state of the power cable is based on the scaled first analysis result.

8. Method according to one of the two preceding claims,

   wherein estimating the state of the power cable is based on whether the scaled first analysis result ($S\_i$) is within or outside a predetermined range (24) around a reference value (26) and/or below or above a predetermined threshold (25), and/or
   wherein a problematic location of the power cable is identified for which the scaled first analysis result is at least by a threshold deviation below the reference value (26); and/or
   the method further comprising: defining a global and/or section wise threshold (25) of the scaled first analysis result for giving an alarm.

9. Method according to one of the three preceding claims, wherein analyzing the covariance related quantities comprises:

   for each location, finding the first analysis value ($M\_i$);
   finding, across the plural locations, one or more local minima (28a, 28b, 28c) of the first analysis value, in order to detect potential problematic locations.

10. Method according to one of the preceding claims,

    wherein analyzing the covariance related quantities comprises, for at least one location, finding, as a second analysis value ($tau\_i$), a location specific time shift for which the covariance related quantity for the respective location is a maximal value,
    wherein estimating the state of the power cable is further based on the second analysis result.

11. Method according to one of the preceding claims,
    wherein analyzing the covariance related quantity comprises:

    analyzing, for at least one location, the behavior of the covariance related quantity at small time shifts, in particular being smaller than the respective second analysis result ($tau\_i$), in particular regarding steepness of increase, in order to obtain a third analysis result, and/or
    analyzing, for at least one location, the behavior of the covariance related quantity at large time shifts, in particular greater than the respective second analysis result ($tau\_i$), in particular regarding steepness of decline and or curvature, in order to obtain a fourth analysis result,
    wherein estimating the state of the power cable is further based on the third analysis result and/or the fourth analysis result, and/or
    applying a decision algorithm and/or rule-based algorithm to derive the state based on one of more features of the covariance related quantities.

12. Method according to one of the preceding claims, further comprising:

    obtaining further load data samples pertaining to plural further points in time;
    obtaining further temperature data samples pertaining to the plural locations along the power cable and pertaining to the plural further points in time;
    deriving, for each location, from the further load data samples and the further temperature data samples, a further location specific covariance related quantity related to a covariance or a correlation of the further load and a further temporal temperature change,
    wherein estimating the state of the power cable is further based on analyzing the further covariance related quantities, in particular involving forming a difference between the scaled first analysis result and a scaled further first analysis result.

13. Method according to one of the preceding claims,

    wherein the plural different time shifts ($\Delta t$) include time shifts ranging from 0 hours to 20 hours, and/or
    wherein the plural points in time cover a range of between one week and ten weeks, in particular between one week and four weeks, and/or

    wherein estimating the state of the subsea electrical power cable includes at least one of:

estimation of an extent of exposure to water and/or soil;
qualitative or quantitative estimation of burial state and/or change of burial state and/or burial depth and/or change of burial depth.

14. Method according to one of the preceding claims,
wherein obtaining the temperature data samples (15, 16, T_i(t)) comprises:
acquiring measuring data of a fibre optic distributed temperature sensing system employing an optical fibre (6) arranged at or in or on the power cable (5),
the temperature sensing system in particular utilizing at least one of:

Raman scattering,
Brillouin scattering,
Raleigh scattering, and/or

wherein obtaining the load data samples comprises:
measuring or deriving electrical power conveyed through the power cable (5), in particular including measuring voltage and/or current and/or power at one or more locations.

15. Arrangement (1) for estimating a state of a subsea electrical power cable (5), in particular distributed temperature sensing system, the arrangement comprising:
a processor (2) adapted:

to obtain load data samples (4) pertaining to plural points in time, the load data samples indicating an electrical load the power cable (5) is subjected to;
to obtain temperature data samples (15, 16, T_i(t)) pertaining to plural locations (x_i) along the power cable (5) and pertaining to the plural points in time (t);
to derive, for each location (x_i), from the load data samples and the temperature data samples, a location specific covariance related quantity (C_i(Δt)) related to a covariance or a correlation of a load related quantity, in particular the load, and a temporal temperature change related quantity, in particular temporal temperature change; and
to estimate the state of the power cable based on analyzing the derived covariance related quantities,

the arrangement in particular further comprising:

an optical fibre (6) arrangeable at or close to the power cable (5);
a light pulse generator (7) adapted to generate primary light pulses (8) and inject them into the optical fibre (6);
a detector (13, 14) adapted to detect secondary light pulses (10, 11, 12) returning from the optical fibre after having interacted with the fibre at plural locations,

the processor (2) being further adapted to process the process the secondary light pulses, in order to derive the temperature data samples (T_i(t)) for the plural locations (x_i).

Fig. 1

Fig. 2

Fig. 3

Fig. 4

Europäisches
Patentamt

European
Patent Office

Office européen
des brevets

# EUROPEAN SEARCH REPORT

**Application Number**

EP 21 18 5900

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUI YI ET AL: "Detecting changes in sediment overburden using distributed temperature sensing: an experimental and numerical study", MARINE GEOPHYSICAL RESEARCHES, SPRINGER-VERLAG, DORDRECHT, NL, vol. 40, no. 3, 21 August 2018 (2018-08-21), pages 261-277, XP036882755, ISSN: 0025-3235, DOI: 10.1007/S11001-018-9365-4 [retrieved on 2018-08-21] | 1,15 | INV. G01R31/58 G01K11/32 G01D5/353 G01B21/18 |
| A | * page 262, right-hand column * * page 264, left-hand column - page 266, right-hand column; figures 1-6 * | 2-14 | |
| X,D | LUX JONATHAN ET AL: "Real-Time Determination of Depth of Burial Profiles for Submarine Power Cables", IEEE TRANSACTIONS ON POWER DELIVERY, IEEE SERVICE CENTER, NEW YORK, NY, US, vol. 34, no. 3, 1 June 2019 (2019-06-01), pages 1079-1086, XP011725447, ISSN: 0885-8977, DOI: 10.1109/TPWRD.2018.2881770 [retrieved on 2019-05-21] | 1,15 | |
| A | * page 1083, right-hand column - page 1085, left-hand column; figures 3-5 * | 2-14 | TECHNICAL FIELDS SEARCHED (IPC)<br><br>G01R<br>G01K<br>G01B |
| A | EP 3 514 488 B1 (MARLINKS NV [BE]) 22 July 2020 (2020-07-22) * paragraphs [0006], [0007], [0011] - [0017], [0055], [0056] * | 1-15 | |
| A | US 2019/094165 A1 (LAUBER THOMAS [DE]) 28 March 2019 (2019-03-28) * paragraphs [0011] - [0018], [0021] - [0025], [0050], [0060]; claim 1 * | 1-15 | |

-/--

| | The present search report has been drawn up for all claims | | |
|---|---|---|---|
| | Place of search<br>**Munich** | Date of completion of the search<br>**7 December 2021** | Examiner<br>**Felicetti, Christoph** |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

**EUROPEAN SEARCH REPORT**

Application Number

EP 21 18 5900

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 2016/298960 A1 (HILL WIELAND [DE] ET AL) 13 October 2016 (2016-10-13)<br>* paragraphs [0002] – [0013], [0039], [0047] – [0051] *<br>————— | 1-15 | |

TECHNICAL FIELDS
SEARCHED        (IPC)

The present search report has been drawn up for all claims

| Place of search | Date of completion of the search | Examiner |
|---|---|---|
| Munich | 7 December 2021 | Felicetti, Christoph |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 18 5900

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2021

| Patent document cited in search report | | Publication date | Patent family member(s) | | Publication date |
|---|---|---|---|---|---|
| EP 3514488 | B1 | 22-07-2020 | NONE | | |
| US 2019094165 | A1 | 28-03-2019 | EP | 3470889 A2 | 17-04-2019 |
| | | | GB | 2566692 A | 27-03-2019 |
| | | | US | 2019094165 A1 | 28-03-2019 |
| US 2016298960 | A1 | 13-10-2016 | CA | 2925544 A1 | 07-10-2016 |
| | | | CN | 106052614 A | 26-10-2016 |
| | | | DE | 102015109493 A1 | 13-10-2016 |
| | | | DK | 3078938 T3 | 12-10-2020 |
| | | | JP | 6816969 B2 | 20-01-2021 |
| | | | JP | 2016201989 A | 01-12-2016 |
| | | | KR | 20160120234 A | 17-10-2016 |
| | | | US | 2016298960 A1 | 13-10-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10117424 A
- EP 0825459 A2
- WO 2014056541 A1
- CN 106052614 A
- WO 2018154275 A1
- EP 3514488 A1

**Non-patent literature cited in the description**

- **XUE-FENG ZHAO ; LE LI ; QIN BA ; JIN-PING OU.** Scour monitoring system of subsea pipeline using distributed Brillouin optical sensors based on active thermometry. *Optics & Laser Technology,* October 2012, vol. 44 (7), 2125-2129
- **J. LUX ; M. OLSCHEWSKI ; P. SCHAFER ; W. HILL.** Real-Time Determination of Depth of Burial Profiles for Submarine Power Cables. *IEEE Transactions on Power Delivery,* June 2019, vol. 34 (3), 1079-1086
- Erosion Risk Mitigation with DTS Based Monitoring System. **FABIEN RAVET ; CRISTIAN SILVA ; RODOLFO GIL ; SIMON MAGUIRE ; ETIENNE ROCHAT.** Abu Dhabi International Petroleum Exhibition & Conference, Abu Dhabi, UAE. November 2020